# EUROPEAN PATENT APPLICATION

(11) **EP 2 555 248 A1**
(43) Date of publication of application: **06.02.2013**
(21) Application number: 12155535.3
(22) Date of filing: 15.02.2012
(51) Int. Cl.: H01L 29/872, H01L 29/66

(54) **Schottky barrier diode and method for manufacturing the same**

(30) Priority: 01.08.2011 KR 20110076558
(71) Applicant: Samsung Electronics Co., Ltd., Suwon-si, Gyeonggi-do, 443-742 (KR)
(72) Inventor: Lee, Jae Hoon, 443-740 Gyeonggi-do (KR)
(74) Representative: Grünecker, Kinkeldey, Stockmair & Schwanhäusser

(57) **Abstract**

A Schottky barrier diode (SBD) is provided, which improves electrical characteristics and optical characteristics by securing high crystallinity by including an n-gallium nitride (GaN) layer (300) and a GaN layer (400) which are doped with aluminum (Al). In addition, by providing a p-GaN layer (500) on the Al-doped GaN layer (400), a depletion layer may be formed when a reverse current is applied, thereby reducing a leakage current. The SBD may be manufactured by etching a part of the Al-doped GaN layer (400) and growing a p-GaN layer (500) from the etched part of the Al-doped GaN layer (400). Therefore, a thin film crystal is not damaged, thereby increasing reliability. Also, since dedicated processes for ion implantation and thermal processing are not necessary, simplified process and reduced cost may be achieved.

## Description

### CROSS-REFERENCE TO RELATED APPLICATION

This application claims the benefit of Korean Patent Application No. 10-2011-0076558, filed on August 1, 2011, in the Korean Intellectual Property Office, the disclosure of which is incorporated herein by reference.

### BACKGROUND

### 1. Field of the Invention

The present invention relates to a Schottky barrier diode (SBD) and a manufacturing method thereof, and more particularly, to an SBD having improved electrical characteristics and optical characteristics while having a reduced leakage current, and a manufacturing method thereof.

### 2. Description of the Related Art

A semiconductor light emitting diode (LED) refers to a semiconductor device that generates light in various colors, through recombination of electrons and holes at a bonding portion between a p-type semiconductor and an n-type semiconductor. In comparison with a filament-based LED, the semiconductor LED has a relatively long lifespan, low power consumption, superior initial driving characteristic, and high vibration resistance. Therefore, demands for the semiconductor LED are steadily increasing. Particularly, in recent days, a nitride semiconductor capable of emitting a blue-based short-wavelength light is drawing a great deal of consideration.

Recently, with rapid and global development of an information and communication technology, a communication technology for ultrahigh-speed and high-capacity signal transmission is developing accordingly. In particular, as demands for a personal phone, satellite communication, a military radar, broadcasting communication, a communication relay, and the like are increasing in regard to wireless communication, demands for a high-speed and high-power electron device are also increasing, the device which is necessary for an ultrahigh-speed information and communication system using a microwave and millimeter wave. In addition, research on a power device used for a high-power device have been actively conducted to reduce energy loss.

In particular, a nitride semiconductor has superior physical properties such as a large energy gap, a high thermochemical stability, a high electron saturation velocity of about 3 × 10⁷ cm/sec, and the like. Therefore, the nitride semiconductor is being actively researched globally since it may be easily applied as not only an optical device but also a high-frequency and high-output electron device. The electron device using the nitride semiconductor has various positive factors such as a high breakdown field (about 3 × 10⁶ V/sec) and maximum current density, stable high-temperature operation, high heat conductivity, and the like.

In case of a heterostructure field effect transistor (HFET) using a hetero-junction structure of a compound semiconductor, since band-discontinuity at a junction interface is high, high-density electrons may be freed in the junction interface, and accordingly an electron mobility may be further increased. The foregoing physical property enables application of semiconductor device as the high-power device.

Currently, besides a silicon (Si)-based power device, a silicon carbide (SiC) device having a large band gap and having a Schottky barrier diode (SBD) structure is being mass-produced as a most frequently used power device. Here, implantation equipment for implanting a carrier into a p-type nitride semiconductor layer to reduce a leakage current is necessary.

Also, high-temperature thermal processing is performed to activate the carrier.

### SUMMARY

An aspect of the present invention provides a Schottky barrier diode (SBD) having improved electrical characteristics and optical characteristics while having a reduced leakage current, and a manufacturing method thereof.

According to an aspect of the present invention, there is provided a Schottky barrier diode (SBD) including a substrate, an n-gallium nitride (GaN) layer disposed on a surface of the substrate and doped with aluminum (Al), a GaN layer disposed on the Al-doped n-GaN layer and doped with Al, a first electrode disposed on the Al-doped GaN layer, and a second electrode disposed on a surface of the substrate, opposite to the surface on which the Al-doped n-GaN layer is disposed.

The SBD may further include a p-GaN layer disposed on the Al-doped GaN layer, and the p-GaN layer may be formed by growing on an etched part of the Al-doped GaN layer, and coming into contact with the first electrode.

Content of Al in the Al-doped n-GaN layer and the Al-doped GaN layer may be in the range from 0.01 % to 1%.

The SBD may further include a buffer layer disposed on the substrate.

The substrate may include one selected from a group consisting of a silicon (Si) substrate, a silicon carbide (SiC) substrate, an aluminum nitride (AlN) substrate, and a gallium nitride (GaN) substrate.

The first electrode may include one selected from a group consisting of nickel (Ni), gold (Au), copper indium oxide (CulnO₂), indium tin oxide (ITO), platinum (Pt), and alloys thereof.

The second electrode may include one selected from a group consisting of chromium (Cr), Al, tantalum (Ta), thallium (Tl), and Au.

According to another aspect of the present invention, there is provided a manufacturing method for an SBD including forming an aluminum (Al)-doped n-gallium nitride (GaN) layer on a surface of a substrate, forming an Al-doped GaN layer on the Al-doped n-GaN layer, forming a second electrode on a surface of the substrate, opposite to the surface on which the Al-doped n-GaN layer is disposed, and forming a first electrode on the Al-doped GaN layer.

The manufacturing method may further include forming a p-GaN layer disposed on the Al-doped GaN layer, and the forming of the p-GaN layer may include etching a part of the Al-doped GaN layer and growing the p-GaN layer on the etched part of the Al-doped GaN layer so that the grown p-GaN layer comes into contact with the first electrode.

The forming of the p-GaN layer may be performed in a temperature range of 1000 °C to 1200°C.

Content of Al in the Al-doped n-GaN layer and the Al-doped GaN layer may be in the range from 0.01% to 1%.

The substrate may be an insulating substrate, and the forming of the second electrode may be performed after removing the insulating substrate and forming a bonding layer to bond the Al-doped n-GaN layer to the second electrode.

### BRIEF DESCRIPTION OF THE DRAWINGS

These and/or other aspects, features, and advantages of the invention will become apparent and more readily appreciated from the following description of exemplary embodiments, taken in conjunction with the accompanying drawings of which:
FIG. 1 is a diagram illustrating a Schottky barrier diode (SBD) according to an embodiment of the present invention;
FIG. 2 is a diagram illustrating an SBD according to another embodiment of the present invention;
FIG. 3 is a graph illustrating photoluminescence (PL) of an undoped gallium nitride (GaN) layer and an aluminum (Al)-doped GaN-layer, according to an embodiment of the present invention;
FIG. 4 is a graph illustrating an electron mobility and a change in carrier concentration according to an Al doping level, according to an embodiment of the present invention;
FIG 5 is a graph illustrating a time-resolved PL (TRPL) of an undoped GaN layer and an Al-doped GaN layer according to time, according to an embodiment of the present invention;
FIGS. 6A and 6B are diagrams illustrating asymmetric reciprocal space maps with respect to an undoped GaN layer and an Al-doped GaN layer, according to an embodiment of the present invention;
FIGS. 7A and 7**B** are diagrams illustrating a transmission electron microscope (TEM) picture of an undoped GaN layer and an Al-doped GaN layer, according to an embodiment of the present invention;
FIG. 8 is a graph illustrating PL characteristics of an n-GaN layer and an Al-doped GaN layer, according to an embodiment of the present invention; and
FIGS. 9A to 9D are diagrams illustrating a process of manufacturing the SBD of FIG. 2.

### DETAILED DESCRIPTION

In the description of embodiments, it will be understood that when a substrate, layer, or pattern is referred to as being "on" another substrate, layer, or pattern, the terminology of "on" and "under" includes both the meanings of "directly" and "indirectly." Further, the reference as to "on" and "under" each layer will be made on the basis of drawings.

In the drawings, the thickness or size of each element may be exaggerated for convenience in description and clarity.

Reference will now be made in detail to exemplary embodiments of the present invention, examples of which are illustrated in the accompanying drawings.

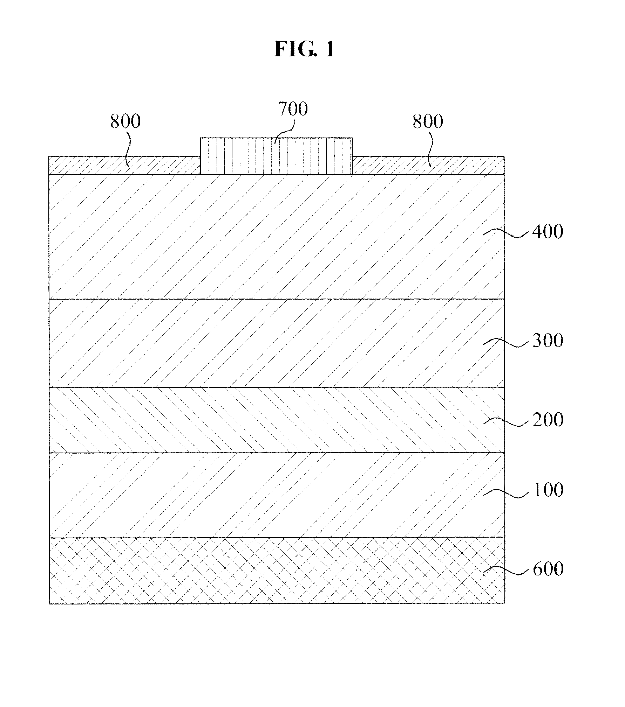

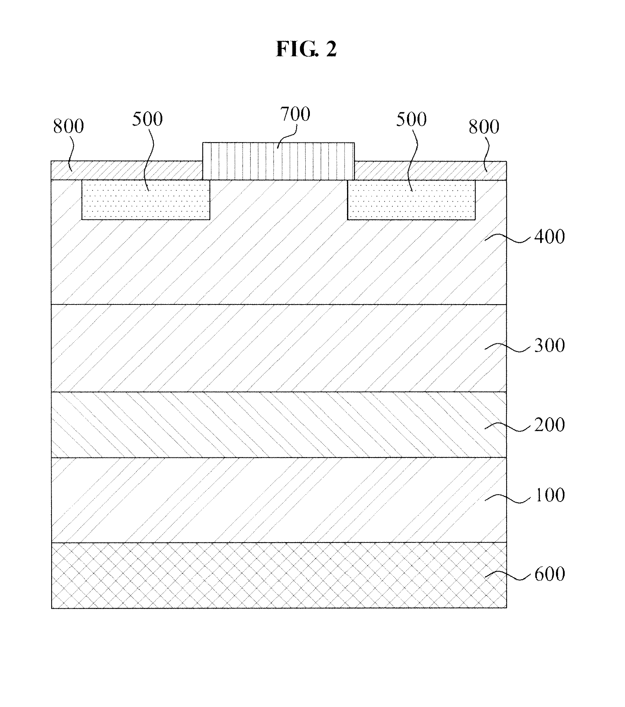

FIG. 1 is a diagram illustrating a Schottky barrier diode (SBD) according to an embodiment of the present invention. FIG. 2 is a diagram illustrating an SBD according to another embodiment of the present invention.

Referring to FIGS. 1 and 2, the SBD according to the embodiments of the present invention includes a substrate 100. a buffer layer 200, an aluminum (Al)-doped n-gallium nitride (GaN) layer 300, an Al-doped GaN layer 400, a p-GaN layer 500, a first electrode 700, a second electrode 800, and an insulating layer 800.

The buffer layer 200 and the Al-doped n-GaN layer 300 may be disposed on the substrate 100. The substrate 100 may be an insulating substrate such as a glass substrate or a sapphire substrate, or a conductive substrate including any one selected from a group consisting of silicon (Si) substrate, a silicon carbide (SiC) substrate, an aluminum nitride (AlN) substrate, and a gallium nitride (GaN) substrate.

The buffer layer 200 may be disposed on the substrate 100. The buffer layer 200 may reduce a lattice mismatch between the substrate 100 and the Al-doped n-GaN layer 300. The buffer layer 200 may be formed at a lower temperature and made of aluminum nitride (AlN) or the like.

The Al-doped n-GaN layer 300 may be disposed on the buffer layer 200. The Al-doped n-GaN layer 300 refers to a layer doped with Al and an n-type dopant. The n-type dopant may include Si, germanium (Ge), selenium (Se), tellurium (Te), carbon (C), and the like. According to the embodiment, the n-type dopant of the Al-doped n-GaN layer 300 may be Si.

In the Al-doped n-GaN layer 300, content of Al may be about 1% or less out of the total doping material. Specifically, the Al content may be in the range from about 0.01 % to about 1%. More specifically, the Al content may be in the range from about 0.2% to about 0.6%, and more specifically, about 0.45%, Thus, since the Al content of the Al-doped n-GaN layer 300 is less than 1%, the Al contained in the n-GaN layer 300 does not produce an Al compound. Since the Al doping is applied to the n-GaN layer 300 by the aforementioned content, a thin film having high crystallinity may be obtained. This is because the Al content compensates for an absence of Ga, thereby increasing the crystallinity of the thin film.

The Al-doped GaN layer 400 may be disposed on the Al-doped n-GaN layer 300. The Al-doped GaN layer 400 is doped with only Al, not with Si. Al content in the Al-doped CaN layer 400 may be in the range from about 0.01% to about 1% out of the total doping material. Specifically, the Al content may be in the range from about 0.2% to about 0.6%, and more specifically, about 0.45%. That is, since the Al-doped n-GaN layer 300 and the Al-doped GaN layer 400 are doped with Al of 1% or less, a thin film having high crystallinity may be obtained. As a consequence, electrical characteristics and optical characteristics of the SBD may be increased.

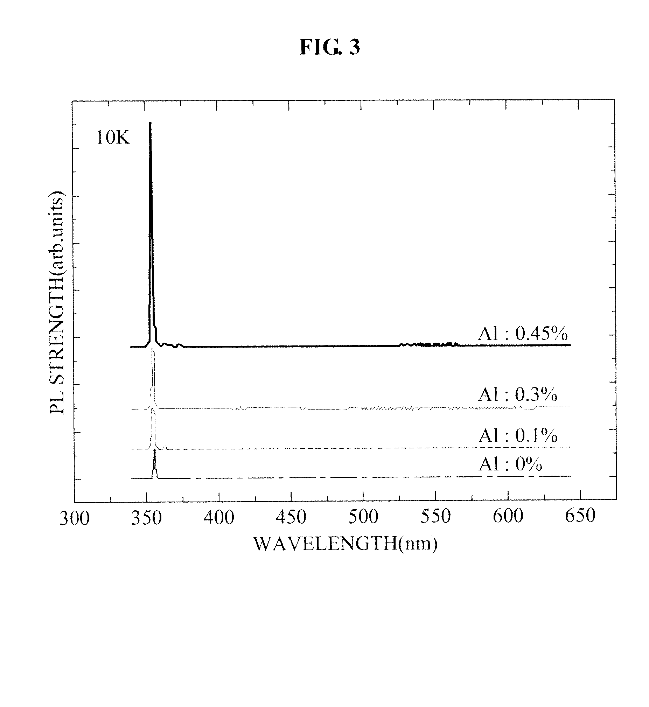

An increase in the crystallinity according to the Al content will be described in further detail with reference to FIGS. 3 through 8.

FIG. 3 is a diagram illustrating photoluminescence (PL) of an undoped GaN layer and an Al-doped GaN-layer, according to an embodiment of the present invention. Referring to FIG. 3, the Al-doped GaN layer shows a higher PL strength than the undoped GaN layer. Furthermore, when the Al content is about 0.45% the PL strength increases about 100 times in comparison with the undoped GaN layer. This is because isoelectronic doping of Al at the time of growing GaN reduces a recombination level, such as a non-radiative recombination center, thereby improving the optical characteristics. That is, since the Al content compensates for the absence of Ga, the optical characteristics may be improved.

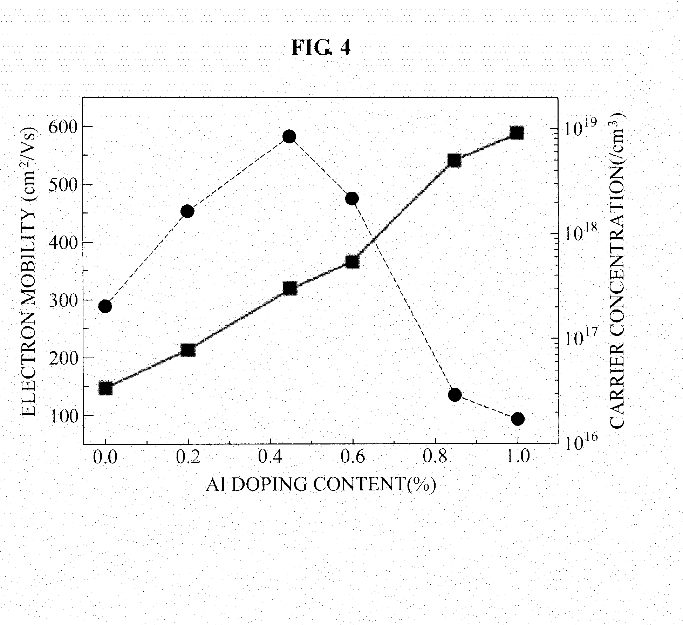

FIG. 4 is a graph illustrating an electron mobility and a change in carrier concentration according to an Al doping content, according to an embodiment of the present invention. Referring to FIG. 4, the carrier concentration increases until the Al content increases up to 1%. As to the electron mobility, the electron mobility is 450 cm²/Vs or greater when the Al content is from about 0.2% to about 0.6%, and is the highest, that is 650 cm²/Vs, when the Al content is about 0.45%. In this instance, the carrier concentration is about 3×10¹⁷/ cm³. As Al is thus included during growth of GaN, defects such as Ga vacancy that captures electrons may be reduced, accordingly increasing crystallinity. At the same time, the number of carriers may be increased. Therefore, the electrical characteristics and the optical characteristics may be improved.

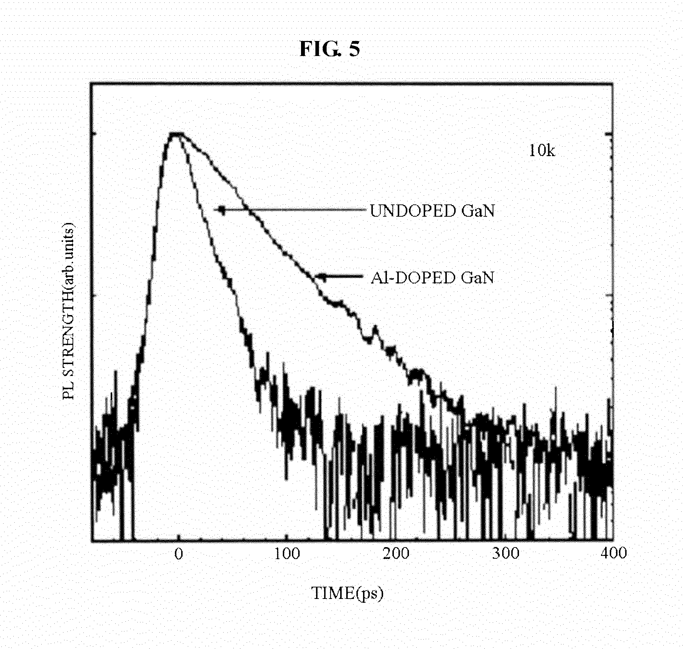

FIG. 5 is a graph illustrating a time-resolved PL (TRPL) of an undoped GaN layer and an Al-doped GaN layer according to time, according to an embodiment of the present invention. Referring to FIG. 5, a band-edge emission decay time of the undoped GaN layer is about 20 picoseconds (ps) whereas that of the Al-doped n-GaN layer increases to about 58 ps. Thus, it can be understood that the recombination center is reduced when the Al doping is applied to the GaN layer.

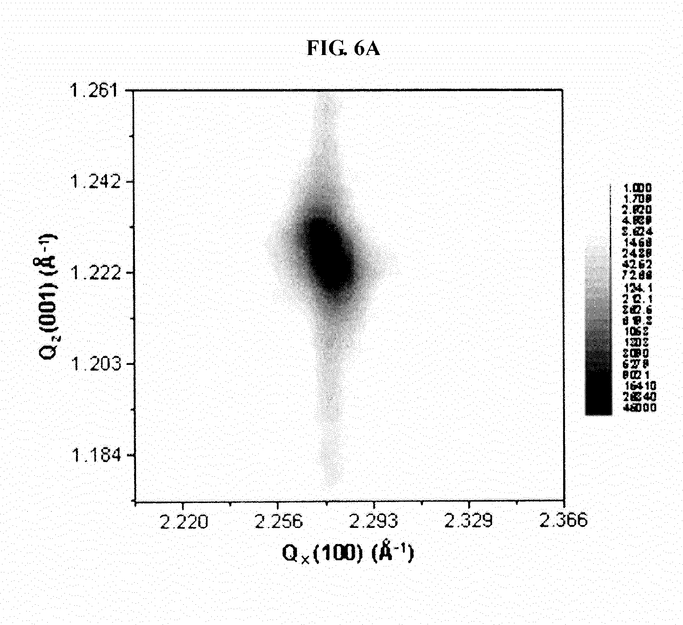

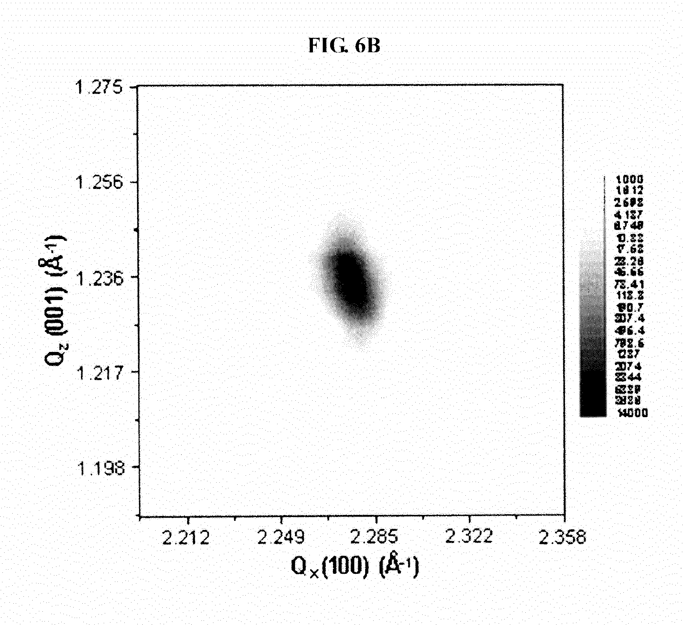

FIGS. 6A and 6B are diagrams illustrating asymmetric reciprocal space maps with respect to an undoped GaN layer and an Al-doped GaN layer, according to an embodiment of the present invention. In FIGS. 6A and 6B, the Al content is 0.45% and a crystallographic direction is (101) direction. Referring to FIGS. 6A and 6B, the maps show information of a crystalline structure caused by thermal vibration and defects, or a structural disorder. A Qₓ-axis relates to a rocking curve of a real lattice and shows that the Al-doped GaN layer has a smaller width than the undoped GaN layer. A Q_{z}-axis relates to an interplanar distance 'd' of a real space. The Q_{z}-axis shows that the undoped GaN layer is widely spread in an annular shape with respect to a reciprocal lattice. In addition, the Al-doped GaN layer is less spread than the undoped GaN layer symmetrically with respect to the vertical Q_{z}-axis. It can be understood that crystallinity is increased since defects are reduced by isoelectric doping of Al.

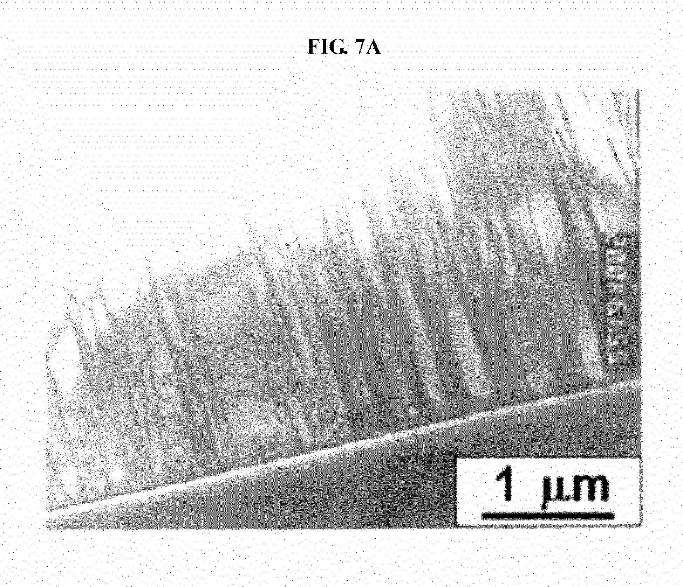

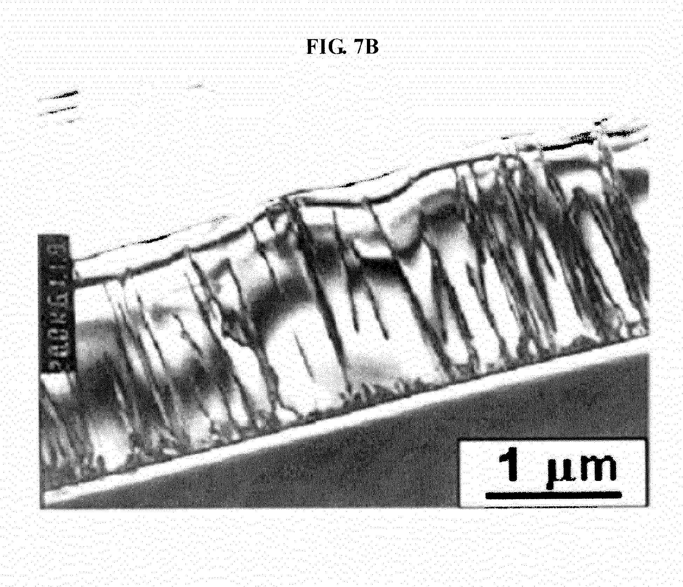

FIGS. 7A and B7 are diagrams illustrating a transmission electron microscope (TEM) picture of an undoped GaN layer and an Al-doped GaN layer, according to an embodiment of the present invention. In FIGS. 7A and 7B, the Al content is 0.45% and a crystallographic direction is (0002) direction. Referring to FIGS. 7A and 7B, screw threading dislocation density of the Al-doped GaN layer is reduced compared to that of the undoped GaN layer. That is, the Ga vacancy and the screw threading dislocation density are correlated. Therefore, the screw threading dislocation density may be reduced by reducing the Ga vacancy by isoelectric doping of Al, thereby improving the electrical characteristics and the optical characteristics.

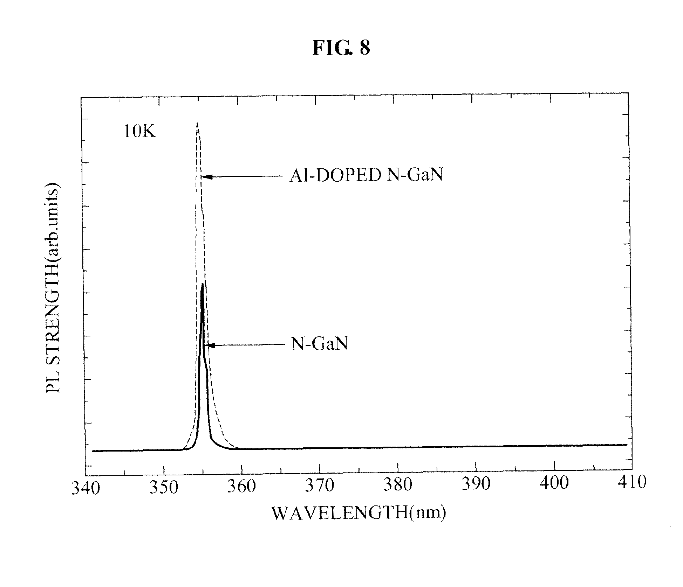

FIG. 8 is a graph illustrating PL characteristics of an n-GaN layer and an Al-doped GaN layer, according to an embodiment of the present invention. Also, when the n-GaN layer is formed, which is an ohmic contact layer for implementing a vertical SBD according to the embodiments of the present invention. defects may be reduced by Al doping, thereby increasing crystallinity.

That is, defects such as the Ga vacancy may be reduced by applying Al doping during growth of a GaN layer and an n-GaN layer. Simultaneously, defects caused by a lattice mismatch, such as dislocation, may be reduced. As a result, the electrical characteristics and the optical characteristics may be improved.

After a part of the Al-doped GaN layer 400 is etched, the p-GaN layer 500 shown in FIG. 2 may be grown on the etched part of the Al-doped GaN layer 400. That is, the p-type GaN layer 500 may be formed by growing from an inside of the Al-doped GaN layer 400 up to a surface of the Al-doped GaN layer 400. The p-GaN layer 500 refers to a layer doped with a p-type dopant. The p-type dopant may include magnesium (Mg), zinc (Zn), beryllium (Be), or the like. The p-GaN layer 500 may contact the first electrode 700 and reduce a leakage current resistance.

Due to the p-GaN layer 500, a p-n junction is formed along the p-GaN layer 500. At the time of the p-n junction, a depletion layer is formed near a p-n junction surface, thereby achieving a high withstand voltage. That is, as free electrons and holes diffuse toward each other at the p-n junction surface, a potential difference locally occurs, thereby achieving a balanced state. Accordingly, a depletion layer without carriers is formed and the withstand voltage is increased.

The depletion layer may prevent the leakage current generated from a Schottky junction area from leaking toward the first electrode. That is, since the depletion layer is formed along the p-GaN layer 500 during application of a reverse voltage, leakage of the current toward the first electrode may be prevented.

In addition, since the p-GaN layer 500 is grown on the etched part of the Al-doped GaN layer 400, damage of the crystal may not be caused, thereby increasing reliability. In addition, since dedicated equipment for ion implantation is unnecessary, process simplification and cost reduction may be achieved.

Here, the first electrode 700 is a Schottky contact disposed on the Al-doped GaN layer 400. The first electrode 700 may include a high Schottky barrier. Height of the Schottky barrier denotes a work function difference which determines characteristics of the Schottky barrier diode. As the work function difference is greater, a forward voltage of the Schottky barrier diode is increased whereas the leakage current resistance during application of the reverse voltage is reduced. Thus, the first electrode 700 may reduce the leakage current by having a high Schottky barrier. The first electrode 700 may be formed of one selected from a group consisting of nickel (Ni), gold (Au), copper indium oxide (CulnO₂), indium tin oxide (ITO), platinum (Pt), and alloys thereof. For example, the alloys may include an alloy of Ni and Au, an alloy of CulnO₂ and Au, an alloy of ITO and Au, an alloy ofNi, Pt, and Au, and an alloy of Pt and Au although no specific limit exists.

The second electrode 600 may be an ohmic contact disposed on a surface of the substrate 100, opposite to a surface on which the Al-doped n-GaN layer 300 is formed. The second electrode 600 may have a low Schottky barrier. By having the low Schottky barrier, the second electrode 600 may enhance the forward current. The second electrode may include one selected from a group consisting of chromium (Cr), Al, tantalum (Ta), thallium (Tl), and Au.

As aforementioned, the Schottky barrier diode according to the embodiments of the present invention may improve the electrical characteristics and the optical characteristics by securing high crystallinity by including the Al-doped n-GaN layer and the Al-doped GaN layer. In addition, since the p-GaN layer is disposed on the Al-doped GaN layer, the depletion layer may be formed when the reverse current is applied, thereby reducing the leakage current. Furthermore, since the p-GaN layer is grown on the etched part of the Al-doped GaN layer, damage of a thin film crystal may be reduced and accordingly the reliability may be increased. In addition, since dedicated equipment for ion implantation is unnecessary, process simplification and cost reduction may be achieved.

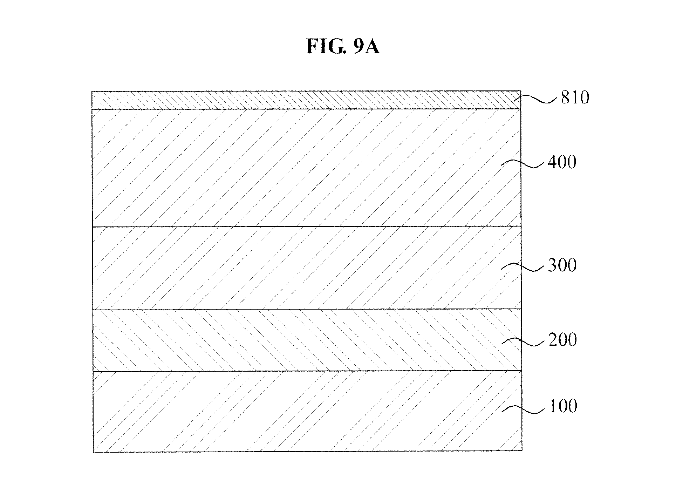

Hereinafter, a method for manufacturing an SBD will be described according to an embodiment of the present invention. FIGS. 9A to 9D are diagrams illustrating a process of manufacturing the SBD of FIG. 2.

Referring to FIGS. 9A to 9D, the manufacturing method of the SBD includes forming the Al-doped n-GaN layer 300 on the surface of the substrate 100, forming the Al-doped GaN layer 400 on the Al-doped n-GaN layer 300, forming the second electrode 600 on a surface of the substrate, which is opposite to the surface on which the Al-doped n-GaN layer 300 is disposed, and forming the first electrode 700 on the Al-doped GaN layer 400.

Additionally, the manufacturing method may further include forming the p-GaN layer 500 on the Al-doped GaN layer 400. After a part of the Al-doped GaN layer 400 is etched, the p-GaN layer 500 may be grown from the etched part to be brought into contact with the first electrode 700.

The p-GaN layer 500 may be formed in a temperature range of about 1000°C to about 1200°C. When the substrate 100 is an insulating substrate, the second electrode 600 may be formed after removing the insulating substrate and forming a bonding layer that bonds the Al-doped n-GaN layer 300 to the second electrode 600.

As shown in FIG. 9A, first, the buffer layer 200, the Al-doped n-GaN layer 300, the Al-doped GaN layer 400, and an insulating layer 810 are formed on the substrate 100. The substrate 100 may be an insulating substrate such as glass substrate or a sapphire substrate, or a conductive substrate including any one selected from a group consisting of Si substrate, a SiC substrate, an AlN substrate, and a GaN substrate.

The buffer layer 200 may be formed by various methods including metal-organic chemical vapor deposition (MOCVD), molecular beam epitaxy (MBE), hydride vapor phase epitaxy (HVPE), and the like although not specifically limited. The buffer layer 200 may be provided to solve a lattice mismatch between the substrate 100 and a layer disposed on the substrate 100 and to enhance growth of the layer disposed on the substrate 100. The buffer layer 200 may be formed at a low temperature and formed of AlN and the like.

The Al-doped n-GaN layer 300 is disposed on the buffer layer 200. The Al-doped n-GaN layer 300 may be grown also by various implementations of the foregoing methods. The Al-doped n-GaN layer 300 may be doped with Al along with an n-type dopant. The n-type dopant may be Si. The Al content may be about 1% or less out of the whole doping material. Specifically, the Al content may be in the range from about 0.01% to about 1%. More specifically, the Al content may be about 0.45%.

The Al-doped GaN layer 400 is disposed on the Al-doped n-GaN layer 300. The Al-doped GaN layer 400 is doped with only Al. The Al content of the Al-doped GaN layer 400 may be in the range from about 0.01 % to about 1% or less out of the total material. Specifically, the Al content may be about 0.45%. Thus, by the content of Al in the Al-doped n-GaN layer 300 and the Al-doped GaN layer 400, a thin film having high crystallinity may be obtained.

The insulating layer 810 may be disposed on the Al-doped GaN layer 400, to be used as an etching mask during photolithography. The insulating layer 810 may be made of one selected from a group consisting of silicon nitride (SiNx), silicon oxide (SiOx), aluminum oxide (Al₂O₃), and SiC.

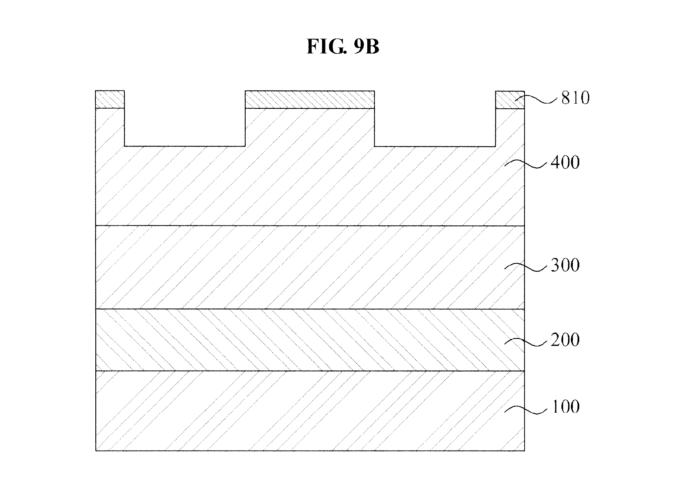

Referring to FIG. 9B, the insulating layer 810 is removed from a region for forming the p-GaN layer 500. That is, the insulating layer 810 is partially removed corresponding to the p-GaN layer 500, thereby exposing a part of the Al-doped GaN layer 400. Only a part of the exposed part of the Al-doped GaN layer 400 may be etched by dry etching. However, the etching method for the Al-doped GaN layer 400 is not limited to dry etching.

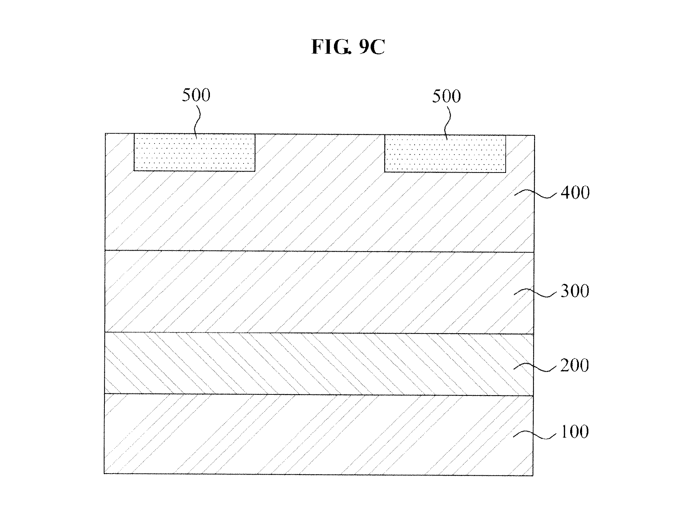

Referring to FIG. 9C, GaN is grown on the etched part of the Al-doped GaN layer 400 and then doped with the p-type dopant, thereby becoming the p-GaN layer 500. The p-GaN layer 500 may be formed by growing GaN by the MOCVD.

The p-GaN layer 500 may be formed in a temperature range of about 1000°C to about 1200°C. Since the p-GaN layer 500 is grown from the Al-doped GaN layer 400 at such a high temperature, damage of the thin film crystal may not be caused and, accordingly, the reliability may increase. In addition, since dedicated equipment for ion implantation is unnecessary, process simplification and cost reduction may be achieved.

Furthermore, due to the p-GaN layer 500, the p-n junction is formed along the p-GaN layer 500. At the time of the p-n junction being formed, the depletion layer is formed near the p-n junction surface, thereby achieving a high withstand voltage. That is, since the depletion layer is formed along the p-GaN layer 500 when a reverse voltage is applied, the leakage current generated from the Schottky junction area may be prevented from leaking toward the first electrode.

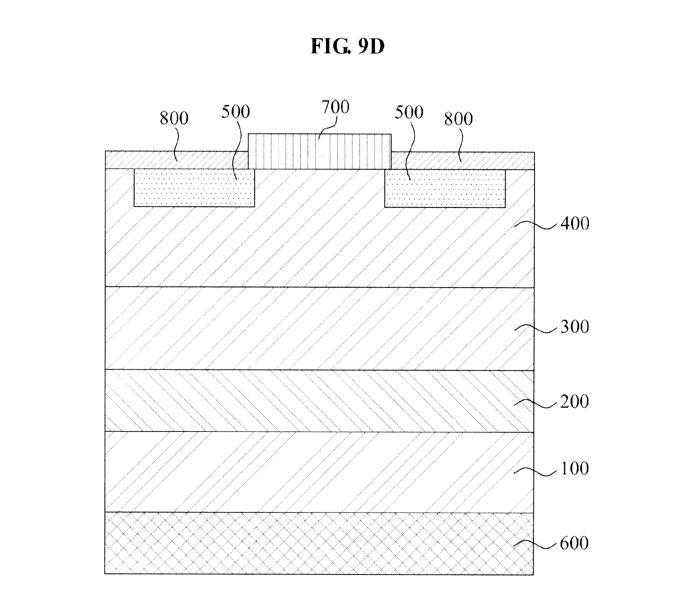

Referring to FIG. 9D, after the p-GaN layer 500 is formed, the second electrode 600 is formed on the surface of the substrate 100. Referring to FIG. 9B, the first electrode 700 is formed on the Al-doped GaN layer 400 through the insulating layer 800. The first electrode 700 may be brought into contact with the p-GaN layer 500. The first electrode 700 may be made of one selected from a group consisting of Ni, Au, CuInO₂, ITO, PT, and alloys thereof. For example, the alloys may include an alloy of Ni and Au, an alloy of CuInO₂ and Au, an alloy of ITO and Au, an alloy of Ni, Pt, and Au, and an alloy of Pt and Au, although no specific limit exists. The second electrode 600 may be formed of one selected from a group consisting of Cr, Al, Ta, Tl, and Au.

Hereinafter, a case where the substrate 100 is an insulating substrate will be described. To avoid redundancy in explanation, wafer bonding and laser lift off methods will be described.

When the substrate 100 is the insulating substrate such as a sapphire substrate, the buffer layer 200, the Al-doped n-GaN layer 300, and the Al-doped GaN layer 400 are formed on the substrate 100. A part of the Al-doped GaN layer 400 is etched and GaN is grown from the etched part of the Al-doped GaN layer 400, thereby forming the p-GaN layer 500. Next, the substrate 104 and the buffer layer 200 are removed by laser lift off processing. After that, a bonding layer (not shown) and the second electrode 600 may be formed. The bonding layer (not shown) may be disposed between the Al-doped n-GaN layer 300 and the second electrode 600, thereby bonding the Al-doped n-GaN layer 300 and the second electrode 600 to each other. The bonding layer (not shown) may include gold-tin (AuSn) or any other material capable of bonding the second electrode 600. The second electrode 600 may be formed after the bonding layer (not shown) is formed. Next, the first electrode 700 may be formed.

The SBD according to the embodiments of the present invention may improve electrical characteristics and optical characteristics by securing high crystallinity by including an Al-doped n-GaN layer and an Al-doped GaN layer. In addition, since a p-GaN layer is formed on the Al-doped GaN layer, a depletion layer may be formed when a reverse current is applied, thereby reducing a leakage current.

The manufacturing method for the SBD according to the embodiments of the present invention etches a part of the Al-doped GaN layer and grows the p-GaN layer from the etched part. Therefore, the thin film crystal may not be damaged and reliability may be secured. In addition, since dedicated equipment for ion implantation and thermal processing are not required, process simplification and cost reduction may be achieved.

Although a few exemplary embodiments of the present invention have been shown and described, the present invention is not limited to the described exemplary embodiments. Instead, it would be appreciated by those skilled in the art that changes may be made to these exemplary embodiments without departing from the principles and spirit of the invention, the scope of which is defined by the claims and their equivalents.

## Claims

1. A Schottky barrier diode (SBD) comprising:
a substrate;
an n-gallium nitride (GaN) layer disposed on a surface of the substrate and doped with aluminum (Al);
a GaN layer disposed on the Al-doped n-GaN layer and doped with Al;
a first electrode disposed on the Al-doped GaN layer; and
a second electrode disposed on a surface of the substrate, opposite to the surface on which the Al-doped n-GaN layer is disposed.

2. The SBD of claim 1, further comprising a p-GaN layer disposed on the Al-doped GaN layer,
wherein the p-GaN layer is formed by growing on an etched part of the Al-doped GaN layer, and coming into contact with the first electrode.

3. The SBD of claim 1, wherein content of Al in the Al-doped n-GaN layer and the Al-doped GaN layer is in the range of 0.0.1% to 1%.

4. The SBD of claim 1, further comprising a buffer layer disposed on the substrate.

5. The SBD of claim 1, wherein the substrate comprises one selected from a group consisting of a silicon (Si) substrate, a silicon carbide (SiC) substrate, an aluminum nitride (AlN) substrate, and a gallium nitride (GaN) substrate.

6. The SBD of claim 1, wherein the first electrode comprises one selected from a group consisting of nickel (Ni), gold (Au), copper indium oxide (CulnO₂), indium tin oxide (ITO), platinum (Pt), and alloys thereof.

7. The SBD of claim 1, wherein the second electrode comprises one selected from a group consisting of chromium (Cr), Al, tantalum (Ta), thallium (Tl), and Au.

8. A manufacturing method for a schottky barrier diode (SBD), comprising:
forming an aluminum (Al)-doped n-gallium nitride (GaN) layer on a surface of a substrate;
forming an Al-doped CaN layer on the Al-doped n-GaN layer;
forming a second electrode on a surface of the substrate, opposite to the surface on which the Al-doped n-GaN layer is disposed; and
forming a first electrode on the Al-doped GaN layer.

9. The manufacturing method of claim 8, further comprising forming a p-GaN layer disposed on the Al-doped GaN layer,
wherein the forming of the p-GaN layer comprises etching a part of the Al-doped GaN layer and growing the p-GaN layer from the etched part of the Al-doped GaN layer so that the grown p-GaN layer is brought into contact with the first electrode.

10. The manufacturing method of claim 9, wherein the forming of the p-GaN layer is performed in a temperature range of 1000 °C to 1200 °C.

11. The manufacturing method of claim 8, wherein content of Al in the Al-doped n-GaN layer and the Al-doped GaN layer is in the range from 0.01% to 1%.

12. The manufacturing method of claim 8, wherein
the substrate is an insulating substrate, and
the forming of the second electrode is performed after removing the insulating substrate and forming a bonding layer to bond the Al-doped n-GaN layer to the second electrode.
